# FASCICULE DE BREVET EUROPEEN

(11) **EP 2 226 679 B1**
(45) Date de publication et mention de la délivrance du brevet: **11.10.2017**
(21) Numéro de dépôt: 10155089.5
(22) Date de dépôt: 01.03.2010
(51) Int. Cl.: G03F 7/00, B29C 33/42

(54) **Procédé de fabrication d'un moule pour la lithographie par nano-impression**
Verfahren zur Herstellung einer Nanoimprintform
Process for fabricating a mould for nanoimprint lithography

(30) Priorité: 03.03.2009 FR 0951337
(43) Date de publication de la demande: 08.09.2010
(73) Titulaire: Commissariat à l'Énergie Atomique et aux Énergies Alternatives, 75015 Paris (FR)
(72) Inventeur: Landis, Stéfan, 38500 Voiron (FR); Morand, Yves, 38000 Grenoble (FR)
(74) Mandataire: Ilgart, Jean-Christophe

(56) Documents cités:
- EP-A- 1 333 324
- WO-A-2007/030527
- WO-A-2008/138361
- FR-A- 2 893 018
- US-A1- 2006 063 387
- US-A1- 2006 186 084
- US-A1- 2006 198 919
- US-A1- 2007 049 028
- US-B1- 6 544 863

## Description

### DOMAINE TECHNIQUE ET ART ANTÉRIEUR

L'invention concerne le domaine dit de la nano-impression, technique de lithographie qui permet de produire une empreinte de type positif en pressant un moule, comportant des motifs de type négatif, pouvant avoir des dimensions micrométriques et/ou nanométriques, dans une couche de résine déposée sur le substrat à structurer.

On peut ainsi réaliser des motifs de quelques nanomètres à plusieurs microns de largeur dans une résine ou un polymère et ensuite les transférer dans le substrat.

Cette technique permet de former rapidement, économiquement et de façon fiable de nombreuses structures à partir d'un seul moule ; l'utilisation du moule permet de ne procéder qu'une seule fois aux techniques coûteuses en temps et/ou en argent qui sont seules à permettre l'obtention de structures de résolutions nanométriques voulues.

Deux approches sont actuellement possibles pour réaliser une lithographie par Nano-impression :
- l'impression thermique qui consiste à chauffer un polymère au-delà de sa température de transition vitreuse et à le mettre en forme avec un moule, généralement en silicium ou en nickel,
- l'impression assistée par UV. Dans ce cas un moule transparent, par exemple en quartz, est pressé dans un monomère ou un pré-polymère réticulé par l'exposition UV durant l'application du moule. Cette technique connaît actuellement un important développement du fait de la possibilité d'alignement entre différents niveaux avec le moule transparent.

La fabrication des moules est une étape critique puisque la résolution, la durée de vie du moule, le taux de production en nano-impression et en nano-moulage et la rentabilité de ces procédés dépendent largement de la qualité et du coût du moule utilisé.

Les motifs à imprimer en relief sur la surface d'un moule sont obtenus :
- soit par lithographie électronique et gravure ionique réactive,
- soit par duplication d'un autre moule préfabriqué (master).

Tenant compte des performances des systèmes de lithographie électronique, de l'interaction électrons-résine/substrat et des propriétés de la résine utilisées, la taille minimale qui peut être obtenue est typiquement de 20 à 50 nm pour des motifs denses (réseaux de lignes ou de plots ou de trous) et peut atteindre 6 à 10 nm pour de motifs dits isolés, par exemple des lignes. Pour définir des structures de taille encore plus petites, un faisceau d'électrons de plus haute énergie peut être utilisé, comme décrit par F.Carcenac et al. dans Microelectron. Eng. 53, p. 163 (2000).

Le procédé de lithographie électronique, par exemple du type dit « e-beam », est généralement utilisé pour fabriquer des moules avec une très haute résolution. En effet les techniques de lithographie optique (lithographie 193 nm en immersion) ne permettent pas de réaliser des motifs avec une résolution inférieure à 30 nm.

Les techniques connues de fabrication de masques permettent mal l'obtention de motifs a trois dimensions, c'est-à-dire que l'obtention de moules de nano-impression permettant d'obtenir plusieurs profondeurs et/ou hauteurs de motifs dans le matériau de pressage est difficilement possible, et ce encore plus dans le cas de réseaux de petites dimensions, inférieures à 10 ou 20 nm.

En effet, si la lithographie électronique permet à la fois de définir des motifs de type 2D, chaque motif ayant la même profondeur, avec des résines dites à seuil ou de types 3D (avec une profondeur variable selon les motifs) avec des résines dites à niveaux de gris, il n'est cependant pas possible de combiner actuellement à la fois les capacités résolvantes ultimes de la lithographie électronique avec sa capacité à former des motifs de types 3D. Il est de plus difficile de combiner ces deux caractéristiques avec une densité importante de motifs.

Une autre technique permet de former des réseaux de motifs de nano-impression denses et de faible dimension. Cette technique est exposée dans la demande de brevet US 6759180 B2, et comporte l'enchainement successif, dans des tranchées prédéfinies, d'étape de dépôt conforme d'oxyde, dépôt de remplissage de Si, polissage, gravure de l'oxyde. Chaque cycle permet de former un motif en silicium au sein d'une tranchée préexistante, formant ainsi deux nouvelles tranchées séparant le nouveau motif des parois de la tranchée préexistante.

Cette technique forme des réseaux denses de motifs séparés par des nano-tranchées. Cependant ce type de procédé ne permet pas d'obtenir de motifs à trois dimensions, c'est-à-dire avec plus de deux niveaux pour les motifs.

Enfin, la connexion électrique entre des motifs conducteurs denses et fins, dits nano-motifs, obtenus sur un substrat par une technique de nano-impression, et le niveau d'intégration supérieur n'est pas simple.

En effet, les niveaux supérieurs étant obtenus par des techniques classiques de lithographies, leurs dimensions sont plus importantes. Une tentative de connexion par formation d'un via en direction du niveau de nano-motifs risque de connecter plusieurs nano-motifs les uns aux autres.

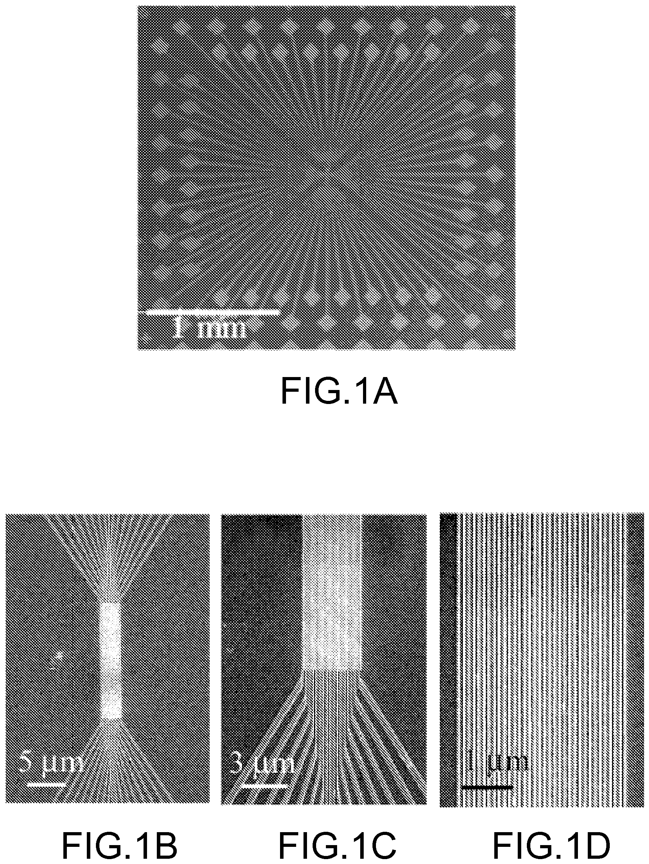

Comme illustré dans les figures 1A à 1D, pour pallier cette difficulté, l'état de la technique propose l'utilisation de structures en arbre qui créent un éloignement local des motifs. Cela permet de créer des points où une prise de contact peut être réalisée au moyen des techniques de lithographie connues. Sur ces figures est représentée une vue globale du réseau avec les points de prise de contact, éloignés du réseau lui-même (figure 1A). Puis, sont représentées des vues aggrandies du réseau, montrant des structures en arbre aux deux extrémités du réseau (figure 1B), le détail d'une des extrémités et de la structure en arbre séparant les lignes du réseau (figure 1C) et enfin une vue rapprochée montrant la densité des lignes du réseau (figure 1D).

Un des défauts majeurs de ce type de solution est la surface occupée. Un autre défaut important est la distance ajoutée aux motifs pour permettre cette structure. Cette distance ajoutée accroit de façon importante la résistance des nano-lignes produites.

Un but de l'invention est de former des structures denses pouvant avoir des motifs à trois dimensions.

Un mode avantageux d'un dispositif selon l'invention permet de plus un adressage électrique de réseaux dense de nano-motifs, constitués par nano-impression d'un moule selon l'invention, occupant moins de surface que les techniques connues.

Le document EP 133324 décrit la formation d'une nano-matrice d'impression.

Le document US 2006/186084 décrit la formation de réseaux de nano-lignes avec un pas qui varie dans l'espace.

Le document US 2007/049028 décrit un procédé de lithographie par nano-impression, pour une utilisation dans la réalisation d'un dispositif semi-conducteur.

### EXPOSÉ DE L'INVENTION

L'invention concerne d'abord un dispositif de nano-impression à trois dimensions selon la revendication 1.

La sélectivité concerne une gravure chimique, sèche ou humide.

Il peut y avoir plus de 2 niveaux dans les zones gravées, ce qui résulte par exemple de 3 étapes de gravure.

Un dispositif selon l'invention comporte donc une pluralité de tranchées ou nano-tranchées séparées par des parois, formant ainsi un réseau de motifs (les sommets des parois) et de nano-tranchées tel que :
a) les motifs sont à un niveau élevé, supérieur aux niveaux des tranchées ou nano-tranchées, et correspondent aux parois des tranchées ou nano-tranchées ; ils sont composés en un matériau différent du fond des tranchées ou nano-tranchées,
b) les tranchées ou nano tranchées comportent des portions avec une première profondeur h1 et des portions avec une profondeur plus importante h2.

Chaque partie profonde de profondeur h2, peut être à une extrémité d'une tranchée ou nano-tranchée, et être délimitée par quatre faces :
- une face composée du premier type matériau, de hauteur h2-h1, selon la direction perpendiculaire au substrat,
- deux faces formées par deux parois latérales composées du deuxième type de matériau,
- une face composée du premier type de matériau, de profondeur h2, et dont le sommet est au même niveau, ou sensiblement au même niveau, que celui des parois latérales entourant la tranchée ou nano-tranchée.

La pluralité de tranchées ou nano-tranchées séparées par des parois latérales peut former un réseau de motifs et de tranchées ou nano-tranchées, chaque portion de tranchée ou nano tranchée de profondeur h2 étant décalée, par rapport à une portion d'une nano tranchée voisine, d'une période P*, selon ladite direction longitudinale.

Les parties profondes des nano-tranchées sont alors, par exemple, alignées selon un axe formant un angle θ (0<θ≤90°) avec ladite direction longitudinale des nano-tranchées, tout en étant deux à deux séparées par une paroi en deuxième matériau.

L'invention concerne aussi un procédé de formation d'un moule d'impression en trois dimensions selon la revendication 6.

L'étape b) peut comporter la formation, sur les couches alternées, d'un masque, comportant au moins une zone ouverte laissant découverte une zone des couches alternées, au moins une partie de la gravure sélective partielle étant réalisée à travers le masque.

Avantageusement, l'étape b) comporte:
- une première gravure sélective partielle avant formation du masque, permettant de graver au moins une partie des couches alternées en premier type de matériau à la profondeur h1,
- la formation du masque,
- une deuxième gravure sélective partielle à travers ladite zone ouverte du masque, permettant de graver une partie des couches alternées en premier type de matériau, déjà gravées lors de la première gravure sélective partielle à la profondeur h1, à la profondeur h2>h1,
- le retrait d'au moins une partie du masque.

Dans cette première variante d'un procédé selon l'invention, une gravure sélective du premier matériau par rapport au deuxième peut être effectuée avant le dépôt du masque. Cela forme alors au moins une tranchée ou nano-tranchée dont le fond est composé du premier matériau entouré par des parois composées du deuxième type de matériau. L'étape de gravure sélective, à travers le masque, forme alors des zones sur-gravées dans chaque tranchée ou nano-tranchée préexistante dont une partie est découverte par le masque de résine. Ensuite, en fin de procédé, le retrait de la résine peut être total.

Plusieurs tranchées ou nano-tranchées sont formées lors de la gravure. Il est formé, avant le dépôt du masque, un réseau de tranchées dont le fond, à un premier niveau de profondeur, est en un premier matériau (profondeur h2), séparé par des motifs de niveau élevé (profondeur h1), composés en deuxième matériau.

En variante, l'étape b) comporte:
- la formation du masque,
- une première sous étape de gravure sélective partielle à travers ladite zone ouverte du masque, permettant de graver une partie des couches alternées en premier type de matériau à une profondeur hᵢₙₜ,
- le retrait d'une première partie du masque,
- une deuxième sous étape de gravure sélective partielle, au moins une partie des couches alternées en premier type matériau, gravées lors de la première sous étape, étant alors gravées à la profondeur h2, et une partie des couches alternées, en premier type matériau, recouvertes par le masque lors de la première sous étape, étant alors gravée à la profondeur h1;
- le retrait d'une deuxième partie du masque.

Selon cette variante d'un procédé selon l'invention, une première sous étape de gravure sélective partielle a lieu, à travers ladite zone ouverte du masque. Il y a alors retrait partiel du masque, par exemple sur un seul des cotés de la zone ouverte dans le masque. Une deuxième sous étape de gravure sélective du premier matériau par rapport au deuxième peut alors être ajoutée, accentuant la topologie formée lors de la l'étape de gravure sélective précédente. Cette deuxième sous étape de gravure prolonge, là où la couche en premier matériau n'a pas pu être gravée précédemment, chaque portion de tranchée ou nano-tranchée pré-gravée par au moins une tranchée ou nano-tranchée à un premier niveau de profondeur entourée par des parois composées du deuxième type de matériau. Le fond de cette ou de ces nano-tranchée(s) est composé du premier matériau. La deuxième sous étape de gravure sélective a aussi lieu dans la ou les zone(s) pré-gravée(s), formant ainsi des portions sur-gravées de nano-tranchées ayant un second niveau de profondeur. Les zones sur-gravées sont alors entourées par:
- d'un premier côté, une tranchée ou nano-tranchée dans une direction longitudinale, parallèle à la surface du substrat,
- d'un deuxième côté, opposé au premier, mais toujours suivant ladite direction longitudinale, une paroi formée dans le premier matériau,
- des parois composées du second matériau suivant la direction perpendiculaire à ladite direction longitudinale.

De préférence, toutes les couches alternées ont le même niveau avant formation du masque.

La zone ouverte dans le masque peut former une tranchée d'un seul tenant, avec deux bords parallèles, disposée suivant un axe faisant un angle θ avec la direction (X) de la longueur des lignes formées par l'alternance de couches, les portions de tranchées gravées dans deux couches voisines, ou les plus proches entre elles car séparées par une paroi en deuxième matériau, ces couches étant composées du premier type de matériau, ayant une période P* entre elles suivant un axe formé par la direction longitudinale X d'extension des couches.

De façon encore avantageuse, dans un dispositif ou un procédé selon l'invention, la période P* selon l'axe X entre deux zones sur-gravées est plus importante que la période minimale pouvant être obtenue pour un réseau de motifs par des moyens de lithographie optique standards.

Dans un procédé et un dispositif selon l'invention, chaque tranchée et éventuellement chaque motif ou paroi, a une épaisseur comprise entre 1 nm et 50 nm, préférentiellement comprise entre 5 nm et 30 nm. Avantageusement, toutes les couches (tranchée ou motif) ont la même épaisseur de, par exemple, environ 10 nm +/- 2 nm ou 7 nm +/- 2 nm ou 5 nm +/- 1 nm. Avantageusement, toutes les couches ont une épaisseur inférieure à 20 nm.

h1 et h2 sont compris entre quelques nanomètres et quelques dizaines de nm, par exemple 50 nm.

L'invention concerne aussi un procédé de formation de motifs dans une résine, comportant une impression, dans une couche de ladite une résine, avec un dispositif de nano-impression tel que décrit ci-dessus : le dispositif est pressé contre, puis dans la résine, jusqu'à ce que cette dernière remplisse complètement les deux niveaux des tranchées ou des nano tranchées. Le dispositif peut alors être éloigné, laissant dans la résine l'impression souhaitée.

Ainsi on produit une empreinte de type positif en pressant un moule selon l'invention, comportant des motifs de type négatif, pouvant avoir des dimensions micrométriques et/ou nanométriques, dans une couche de résine déposée sur le substrat à structurer. On peut ainsi réaliser des motifs de quelques nanomètres à plusieurs microns de largeur dans une résine ou un polymère et ensuite les transférer dans un substrat.

Un tel procédé peut comporter la formation, sur un substrat, d'un réseau de nano-motifs en résine, comportant des plots dont les sommets sont situés à une première hauteur h'2 par rapport à une surface dudit substrat, et des motifs de hauteur h1'<h'2 par rapport à la même surface et s'étendant suivant une direction commune d'extension des motifs.

Un tel procédé peut en outre comporter la formation de contacts entre lesdits plots et des lignes d'interconnexion.

Il est en effet alors possible de connecter le réseau de motifs conducteurs obtenu par nano-impression utilisant un dispositif selon l'invention en formant, par exemple par des moyens de lithographie optique, un réseau de lignes orientées localement selon l'axe Y, perpendiculaire à la direction d'élongation des tranchées, au-dessus du réseau pré-cité. Ce réseau de lignes a préférentiellement une période de valeur égale à la période P* des portions de nano-tranchées sur-gravées suivant la direction de la longueur des nano-tranchées. Les zones du moule ayant une profondeur plus importante conduisent, lors de la formation de motifs par nano-impression, à former des portions de motifs plus élevées.

La prise de contact entre le niveau supérieur (les plots, hauteur h'2) et les motifs de hauteur h'1, se fait alors sur les plots, ce qui évite que la formation d'un via par des moyens de lithographie optique et ne crée de court-circuits entre deux nano-motifs.

Dans un procédé ou un dispositif selon l'invention, les matériaux composant l'alternance de couches alternées et/ou formant le fond et les flancs des nano-tranchées sont choisis parmi Si, SiGe, SiO2, HfO2, Si3N4, ZrO. Par exemple les couples de matériaux retenus pour le premier matériau et le deuxième matériau peuvent être Si/SiGe, Si/SiO2, ou le couple HfO2/SiO2, ou le couple SiO2/Si3N4, ou le couple ZrO2/SiO2 ou encore des couples de matériaux métalliques. Il est encore possible d'incorporer plus de deux matériaux parmi ceux pré-cités, en choisissant des matériaux pouvant être gravés de façon sélective les uns par rapport aux autres de façon à avoir, par exemple, des variations des profondeurs individuelles des nano-tranchées, l'une par rapport à l'autre.

### BRÈVE DESCRIPTION DES DESSINS

- Les figures 1A à 1D comportent quatre photographies, à quatre niveaux de zoom, d'une structure conventionnelle permettant d'établir un contact électrique entre un niveau supérieur et un niveau inférieur composée de nano-tranchées obtenues par nano-impression.
- Les figures 2A à 6C illustrent un procédé selon l'invention, dans lequel la gravure des nano-tranchées est faite après dépôt et retrait de la résine.
- Les figures 7A à 10C illustrent un procédé selon l'invention, dans lequel la gravure des nano-tranchées est faite avant le dépôt de la résine.
- Les figures 11A - 11C illustrent un dispositif selon l'invention comportant des zones sur-gravées en bout de nano-tranchées.
- Les figures 12A - 12C illustrent un dispositif selon l'invention comportant des zones sur-gravées au milieu des nano-tranchées.
- La figure 13 illustre les motifs obtenus par nano-impression d'un dispositif selon la figure 11.
- La figure 14 illustre le mode de connexion de motifs obtenus par nano-impression d'un dispositif selon la figure 11 avec un niveau électrique supérieur.
- Les figures 15A - 15E illustrent un procédé de formation d'une couche composite.

### EXPOSÉ DÉTAILLÉ DE MODES DE RÉALISATION PARTICULIERS

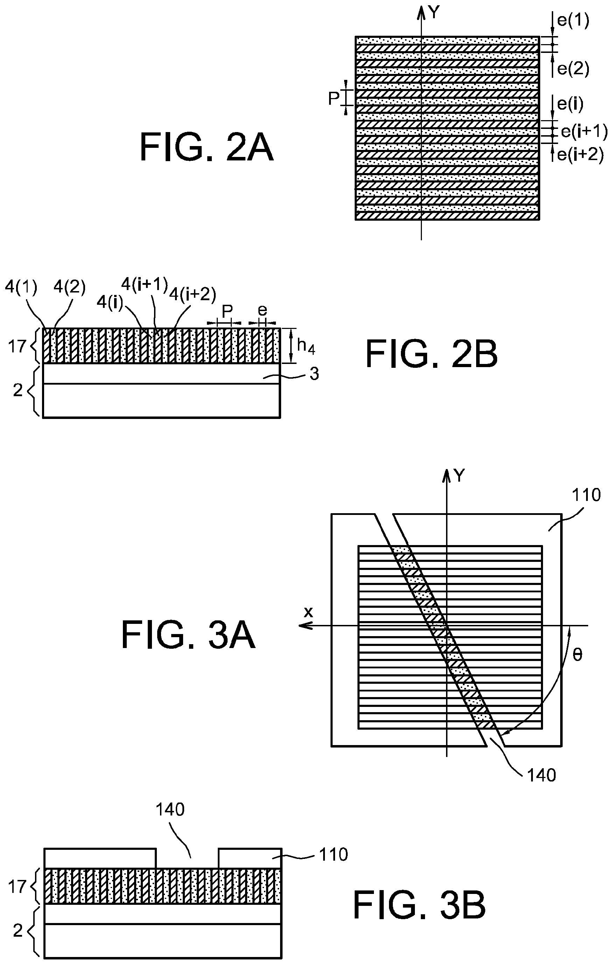

Des modes de réalisation de procédés selon l'invention sont présentés en figures 2A à 10C, où une figure A est une vue du dessus, une figure B une coupe de la figure A selon l'axe Y et une figure C une coupe de la figure A selon l'axe X, les axes X et Y étant deux axes définissant un plan parallèle à la surface du substrat ou du dispositif.

On sélectionne d'abord un substrat 2 qui peut par exemple être en matériau semi-conducteur, ou en nickel ou en quartz ou en tout autre matériau adéquat.

Ce substrat présente une surface qui définit un plan XOY, ou plan principal du substrat.

Sur ce substrat 2 est réalisé au moins une couche composite 17 contenant « n » couches 4(i), i=1..n, (figures 2A et 2B), parallèles entre elles et toutes sensiblement perpendiculaire au plan xOy. Dans le cas des procédés et dispositifs présentés, une couche superficielle 3 en oxyde peut être comprise entre la couche composite et le substrat. De façon alternative, le dispositif ne contient pas de couche superficielle 3.

Les couches 4(i) sont composées de façon alternée de deux types de matériaux pouvant être gravés de façon sélective l'un par rapport à l'autre. On dit que la gravure est sélective entre deux matériaux si, pour une gravure (par exemple chimique, sèche, ou humide), un des deux matériaux est gravé avec une vitesse de gravure sensiblement plus importante (par exemple 10 fois ou 100 fois plus importante) que la vitesse de gravure de l'autre matériau.

La couche composite 17 a une hauteur h4 mesurée suivant une direction Z sensiblement perpendiculaire à la surface du substrat 2. La période d'alternance P, entre deux couches 4(i) et 4(i+2) composées du même type de matériau, est égale à la somme de l'épaisseur e(i) d'une couche en premier matériau et de l'épaisseur e(i+1) d'une couche en deuxième matériau.

Préférentiellement, pour un même type de matériau, les épaisseurs des différentes couches sont identiques. L'épaisseur de chaque couche est par exemple comprise entre 1 nm et 20 nm, avantageusement comprise entre 1 nm et 10 nm. Avantageusement, toutes les couches 4(i) ont une épaisseur e(i) identique, par exemple de 10 nm ; dans le cas de deux matériaux, la période P est alors égale à 2*e, par exemple 20 nm.

A titre d'exemple, les premier et deuxième matériaux peuvent être respectivement à base de SiGe et à base de Si. Les premiers et deuxièmes matériaux peuvent, à l'inverse, être respectivement Si et SiGe. D'autres couples de matériaux sont possibles, tel qu'il est décrit ci-après. Il peut éventuellement y avoir plus de deux types de matériaux composant l'alternance de couche 4(i), chaque type de matériau pouvant être gravé de façon sélective par rapport aux autres.

La couche 17 peut être formée par exemple par un procédé du type de celui de la demande de brevet US 6759180 B2, et comporte alors l'enchaînement successif, dans des tranchées prédéfinies, d'une étape de dépôt conforme d'oxyde servant à rétrécir la tranchée initiale jusqu'à atteindre une épaisseur e, puis d'une étape de remplissage des tranchées d'épaisseur e par du Silicium, puis des étapes de polissage, et de gravure de l'oxyde. Chaque cycle permet de former un motif en silicium au sein d'une tranchée préexistante, formant ainsi deux nouvelles tranchées séparant le nouveau motif, de largeur e, des parois de la tranchée préexistante.

Il est possible d'enchaîner de façon successive plusieurs cycles, en choisissant, pour chaque cycle, les épaisseurs d'oxyde de façon à avoir de épaisseurs e de l'ordre de 5 nm à 50 nm, pour former un réseau de n motifs d'épaisseur e, séparés par des tranchées d'épaisseur e. En ne procédant pas à l'étape de gravure de l'oxyde dans le dernier cycle, il est possible d'obtenir une structure de couche composite 17 du type présenté ci-dessus, pouvant être utilisé dans le cadre d'un procédé suivant l'invention. Les deux matériaux composant les couches 4(i) sont alors Si et SiO2.

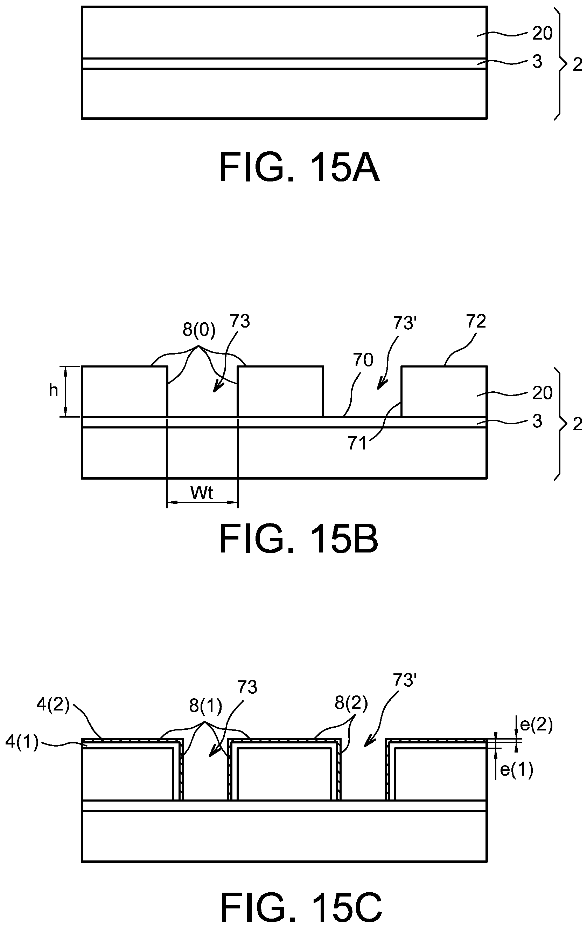

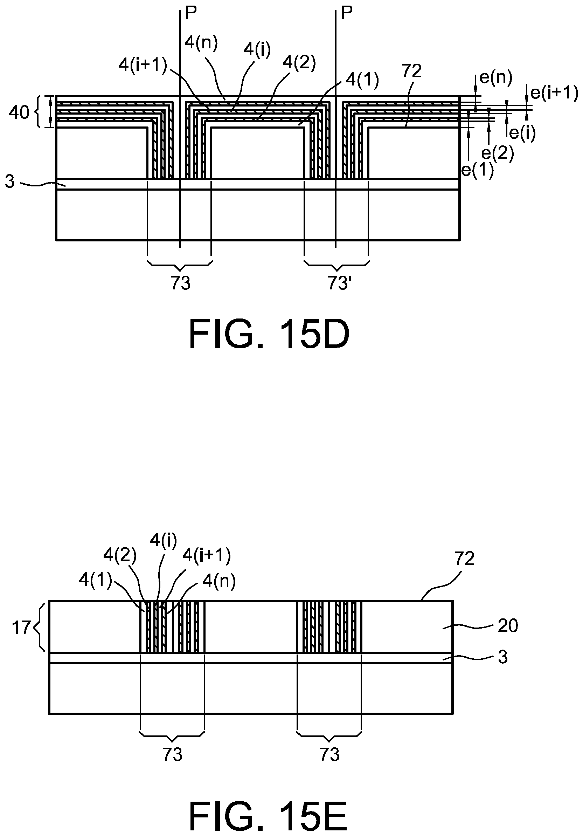

Un deuxième exemple de procédé de formation d'une couche composite 17 est illustré en figures 15A à 15E.

La formation de la couche composite met en oeuvre, dans cet exemple, un substrat de type semi-conducteur sur isolant, c'est-à-dire, un substrat comportant une couche isolante enterrée 3 séparant une couche superficielle 20 fine de hauteur h, en matériau semi-conducteur, d'un substrat épais 2 assurant la rigidité de l'ensemble (figure 15A). Le matériau de la couche isolante enterrée 3 est choisi de façon à limiter et/ou empêcher le dépôt des matériaux composant les couches alternées 4(i).

Cette couche isolante peut avantageusement être en oxyde de silicium et le film superficiel en silicium.

Une ou plusieurs tranchées 73, 73', de largeur Wₜ, de profondeur h, sont gravées dans la couche superficielle 20, par exemple par photolithographie. La couche isolante enterrée 3 formant couche d'arrêt pour cette gravure. Le fond des tranchées 73 est donc constitué par la couche 3 en matériau isolant (figure 15B). On distingue alors entre trois types de surfaces sur ou dans le substrat : les fonds 70 de tranchées, les flancs 71 des tranchées et le sommet 72 du substrat (la partie supérieure du substrat 2, qui est non affectée par la gravure des tranchées).

Le matériau formant la couche isolante enterrée 3 et formant donc le fond des tranchées ne permettant pas le dépôt des matériaux prévus pour les couches conformes alternées 4(i), la surface active de dépôt 8(0), surface en un matériau compatible avec le dépôt des matériaux des couches alternées 4(i) choisies, est composée par le sommet 72 du substrat ainsi que par les flancs 71 des tranchées 73. Cette surface active donc est composée presque uniquement de surfaces de la couche superficielle 20.

Une épaisseur e(1) d'une première couche 4(1), de faible rugosité, et en un premier type de matériau, est déposée de façon conforme sur l'ensemble de la surface 8(0) (figure 15C). D'une manière générale, on appelle couche conforme une couche épousant la topologie de la surface 8(0) sur laquelle elle est déposée. Ce premier type de matériau est choisi de façon à pouvoir être gravé de façon sélective par rapport au substrat 2. Il est par exemple en SiGe. Cette couche a une surface libre 8(1).

Ensuite, sur cette surface 8(1) en un premier matériau est déposée une couche 4(2), conforme et de faible rugosité, d'épaisseur e(2) en un deuxième type de matériau (figure 15C). Le matériau de la couche 4(2) est choisi de manière à pouvoir être gravé de façon sélective par rapport au matériau de la couche 4(1). D'une manière générale, dans toute la présente demande, une gravure est dite sélective entre deux matériaux si, lors de l'étape de gravure, la vitesse de gravure de l'un des deux matériaux est substantiellement supérieure à la vitesse de gravure de l'autre matériau, par exemple 10 à 1000 fois supérieure à celle-ci. Préférentiellement le matériau de la couche 4(2) est gravé à la même vitesse que le substrat 2, avantageusement ce matériau est le même que celui du substrat, c'est par exemple du Silicium.

Ces étapes sont répétées de façon à obtenir n couches conformes 4(1) à 4(n) d'épaisseurs e1 à e(n) formant un film composite 40 d'épaisseur hₙ sur l'ensemble de la topologie (figure 15D). La couche 4(i+1) est déposée sur la surface 8(i) de la couche i ; la couche 4(i+1) étant du type de matériau choisi de façon à pouvoir être gravé de façon sélective par rapport au type de matériau composant la couche sous-jacente 4(i).

Est ainsi formée une alternance entre les deux types de matériaux cités précédemment, qui peuvent être gravés sélectivement l'un par rapport à l'autre :
- les couches impaires 4(1) à 4(2x+1) étant composées du premier type de matériau,
- et les couches paires, qui sont disposées de manière alternée avec les couches impaires, formées à base du deuxième type de matériau. Ces couches paires sont référencées 4(2) à 4(2x), ou 4(2) à 4(2x+2), selon qu'il y a un nombre total impair ou pair de couches déposées sur le substrat.

Chacune des épaisseurs e(1) à e(n) est comprise entre quelques nanomètres et quelques dizaines de nanomètres, par exemple, entre 1 nm et 50 nm, préférentiellement entre 5 nm et 30 nm.

Avantageusement, toutes les couches ont une même épaisseur, par exemple environ 10 nm +/- 2 nm.

Le dépôt de chaque couche peut être fait par exemple par CVD (notamment par épitaxie) ou PECVD.

La présence du matériau isolant 3, composant le fond des tranchées, ne permet pas le dépôt des couches conformes alternées (figure 15D). Il n'y a donc pas de dépôt des couches 4(i) suivant le fond des tranchées. Les portions de couches alternées présentes dans les tranchées 73, 73' sont uniquement orientées perpendiculairement au plan moyen du substrat 2 et sont déposées au moins suivant les deux flancs 71 de chaque tranchée 73 de manière symétrique par rapport au plan Pₜ passant par le centre de chaque tranchée 73.

Dans le cas où certaines tranchées 73 ne sont pas remplies entièrement par la couche composite 40, il est ensuite avantageusement procédé au remplissage des parties non remplies de ces tranchées par un matériau de remplissage choisi de façon à pouvoir être gravé de façon sélective par rapport au type de matériau composant la dernière couche conforme 4(n) de l'empilement 40. Avantageusement cette dernière couche conforme 4(n) est telle que le matériau de remplissage puisse être gravé à une vitesse proche de celle du matériau du substrat. Par exemple le matériau de remplissage est un matériau du type de celui composant le substrat.

Ensuite, le dispositif est aminci, par exemple lors d'un polissage mécano-chimique, de façon à enlever au moins les portions de la couche composite 40 qui surmontent le champ 72 du substrat et ainsi obtenir un dispositif dans lequel l'alternance des deux matériaux, pouvant être gravés de façon sélective l'un par rapport à l'autre, n'est présente que dans les zones correspondant aux tranchés 73, 73' (figure 4E).

Il peut ainsi être formé une couche composite 17, comportant dans cet exemple deux réseaux de couches alternées 4(i) compris dans des tranchées larges 73, séparées par des portions en matériau du substrat 20. Chaque réseau de couches alternées 4(i) est, dans cet exemple, composé d'une alternance de couches de Si et de couches de SiGe. Il est possible de réaliser cette alternance de couches avec d'autres couples de matériaux et même avec plus de 2 matériaux différents, ayant des vitesses de gravures différentes, notamment choisis parmi les matériaux cités ci-dessous.

Un mode de réalisation d'un procédé selon l'invention est décrit en figures 3A à 6C.

On part d'une structure comportant un substrat 2 muni d'au moins une couche composite 17 contenant n couches 4(i), i=1..n. Cette structure et des exemples de procédés de réalisation de cette structure ont déjà été décrits ci-dessus, notamment en liaison avec les figures 2A et 2B et 15A à 15E.

Sur la couche composite 17 de couches alternées est déposé un masque de lithographie 110 (figures 3A et 3B). Ce masque peut être en résine de photolithographie et sera appelé résine dans la suite de la description. Une zone découverte 140 est formée en éliminant la résine dans la zone non couverte par le masque. Cette zone découverte laisse donc apparaître localement l'alternance de couches 4(i). Avantageusement cette zone découverte dans la résine a la forme, dans le plan XY, d'une tranchée 140 de largeur W. Les parois de cette tranchée sont rectilignes, perpendiculaires au plan XY, parallèles entre elles et forment un d'angle θ (0<θ≤90°) par rapport à la direction locale X des couches alternées 4(i). Dans la tranchée 140, la longueur L', mesurée suivant l'axe X, de la portion de chaque couche 4 (i) non couverte par la résine 110 est alors égale à W/(cos 90-θ).

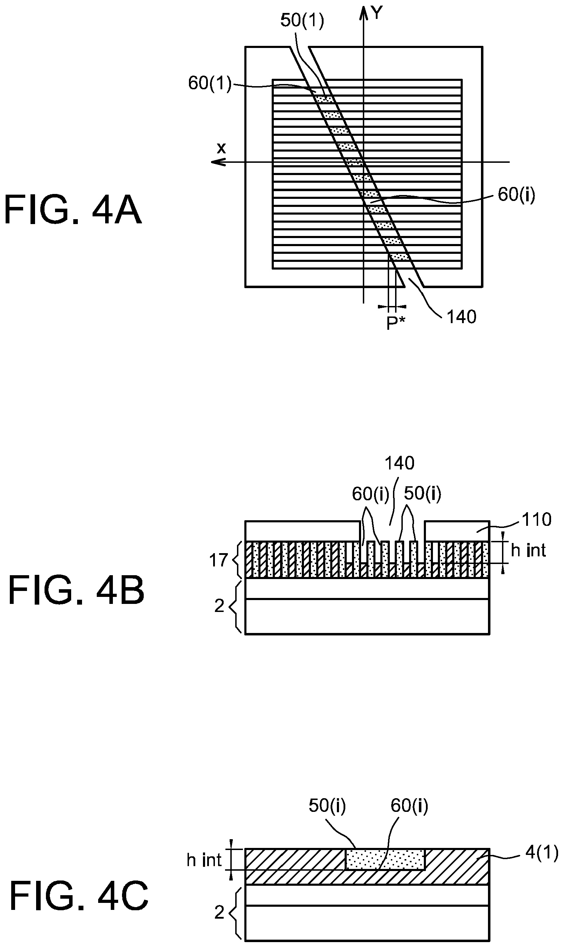

Il est ensuite procédé à une gravure sélective d'un des deux types de matériau (figures 4A, 4B et 4C). A titre d'exemple, le matériau gravé préférentiellement est le premier matériau. La gravure de ce premier matériau conduit à former localement, dans les couches 4(i) en premier matériau, des portions de tranchées ou de nano-tranchées 60(i), à une profondeur intermédiaire hᵢₙₜ (par exemple de l'ordre de quelques dizaines de nm) deux nano-tranchées étant séparées par des parois 50(i) composées dans le second type de matériau. Ce second type de matériau peut aussi être gravé mais il l'est moins que le premier. Le niveau des sommets des parois 50(i) séparant les nano-tranchées 60(i) sera noté « niveau haut » par la suite. Ici, et dans tout le présent document, les profondeurs hᵢ (i=int, 1, 2,...) sont mesurées par rapport à la surface des couches en deuxième matériau, qui sont peu affectées par la gravure que les couches en premier matériau.

Dans le cas avantageux d'une ouverture dans la résine 110 en forme de tranchée 140 ayant un d'angle θ par rapport à la direction locale X des couches alternées, il est formé une périodicité P* suivant l'axe X entre deux portions de nano-tranchées 60(i) pré-gravées présentes sur deux couches alternées voisines en premier matériau 4(i) et 4(i+2). P* est alors tel que P* = p/tan(θ).

La gravure est, dans cet exemple, isotrope, le premier matériau est localement gravé sous la couche de résine 110 (figures 4A, 4B et 4C) et la longueur L des portions de nano-tranchées pré-gravées est alors strictement supérieure à L', longueur, suivant l'axe X, de la portion de chaque couche 4(i) non couverte par la résine 110.

Alternativement, la gravure peut être anisotrope et grave uniquement les portions du premier type de matériau non couvertes par la résine 110. La longueur L des portions de nano-tranchée pré-gravée est alors égale à la longueur L'. Cette configuration est illustrée dans le mode de réalisation suivant.

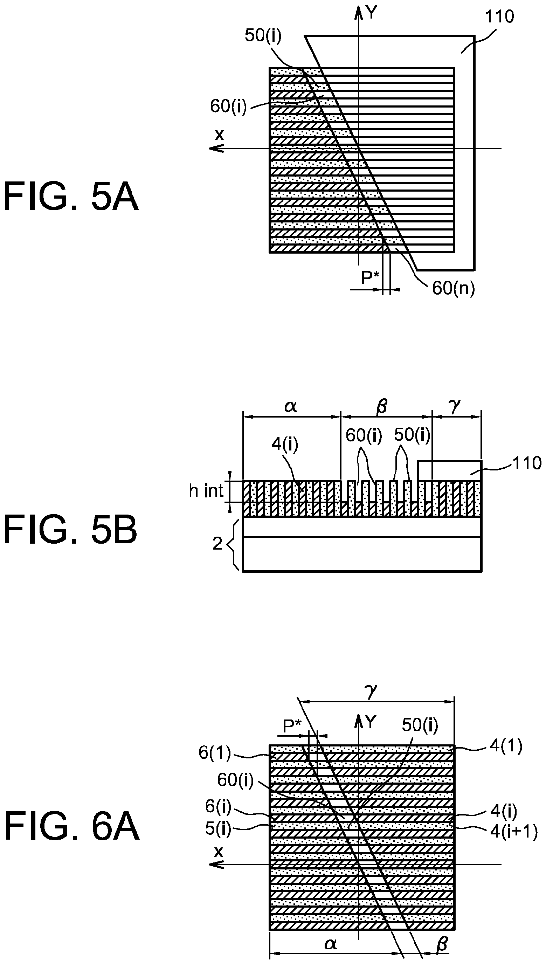

Suite à la gravure, une portion de résine 110 de résine est éliminée (figures 5A et 5B), cette portion éliminée est préférentiellement la résine présente d'un seul des côtés de la zone découverte 140. Le dispositif comporte alors au moins trois zones :
- une zone (α), dans laquelle il n'y a pas encore eu de gravure et où les couches 4(i) composées du premier type de matériau sont au niveau des couches en deuxième type de matériau,
- une zone (β), qui correspond à la forme de la tranchée 140, contenant les portions de nano-tranchées 60(i) pré-gravées ayant une profondeur intermédiaire hᵢₙₜ,
- une zone (γ), recouverte de résine 110, dans laquelle il n'y a pas eu de gravure et où les couches 4(i) composées du premier type de matériau sont au niveau des couches en deuxième type de matériau.

Puis, une deuxième étape de gravure sélective du premier type de matériau a lieu. Il y a alors gravure du premier type de matériau en tout point de l'alternance de couches 4(i) qui n'est pas recouvert par de la résine 110, c'est-à-dire dans les zones (α) et (β).

Tous ces points sont alors gravés d'une même profondeur h1. Cela conduit à former :
- des nano-tranchées 6(i) de profondeur h1 dans les couches en premier matériau de la zone (α) ayant initialement un niveau haut, égal à celui des couches en deuxième matériau;
- des portions de nano-tranchées 60(i) plus profondes ayant une profondeur h2 telle que h2=h1+hᵢₙₜ dans les portions de nano-tranchées pré-gravées 60(i) de la zone (β).

Les parties des couches composées du premier type de matériau appartenant à la zone (γ) sont recouvertes de résine 110 et ne sont donc pas gravées.

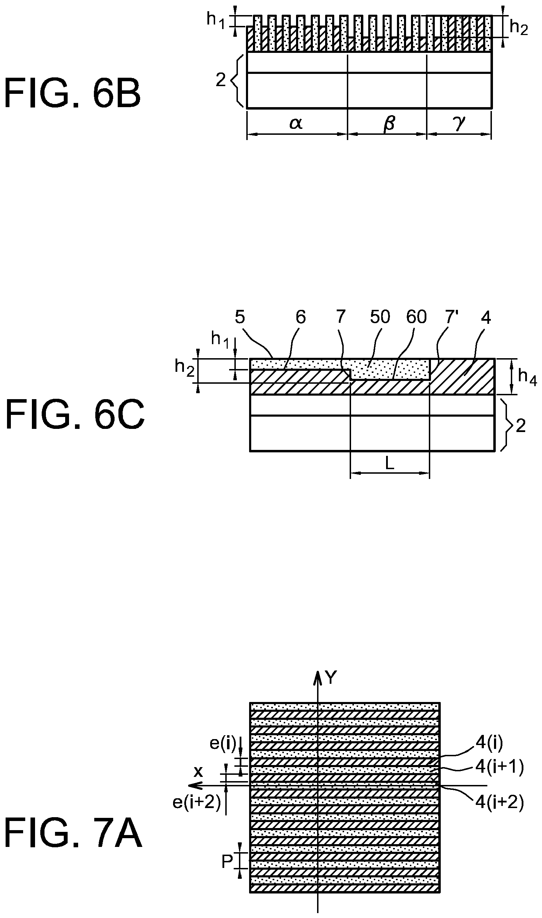

Enfin, il est procédé au retrait de la résine 110 restante (figures 6A, 6B et 6C). Les zones sur-gravées 60(i), de profondeur h2, ont alors dans le sens de la longueur de l'alternance de couches 4(i), d'un coté une tranchée ou nano-tranchée 6(i) de profondeur h1, et de l'autre coté une paroi composée du premier type de matériau et dont le niveau est identique à celui des couches composées du deuxième type de matériau. La figure 6C représente une coupe suivant l'axe X, pour une tranchée ou nano-tranchée 6 quelconque dans le dispositif.

Le réseau de couches alternées comporte alors trois zones:
- une zone « profonde » (β) composée d'une alternance de portions de nano-tranchées 60(i) de profondeur h2 séparées par des parois 50(i) composées par le deuxième type de matériau ; cette zone a les caractéristiques géométriques déjà indiquées ci-dessus : une largeur W et un angle θ par rapport à la direction locale X des couches alternées 4(i), les portions de profondeur h2 ayant une période P* selon cet axe X,
- d'un coté de la zone profonde, un réseau (α) de nano-tranchées 6(i) de profondeur h1, dont le fond est composé du premier type de matériau, séparées par des parois 5(i), de niveau haut, composées du second type de matériau,
- de l'autre coté de la zone profonde, un réseau (γ) de couches alternées 4(i) ayant le même axe de direction local des couches que le réseau de nano-tranchées, chacune des couches alternées 4(i) ayant une même hauteur h4, identique à la hauteur initiale, avant gravure, des couches 4(i).

Un autre mode de réalisation d'un procédé selon l'invention est décrit en figures 7A à 10C.

On part d'une structure comportant un substrat 2 muni d'au moins une couche composite 17 contenant n couches 4(i), i=1..n. Cette structure et des exemples de procédés de réalisation de cette structure ont déjà été décrits ci-dessus en liaison avec les figures 2A et 2B et 15A à 15E.

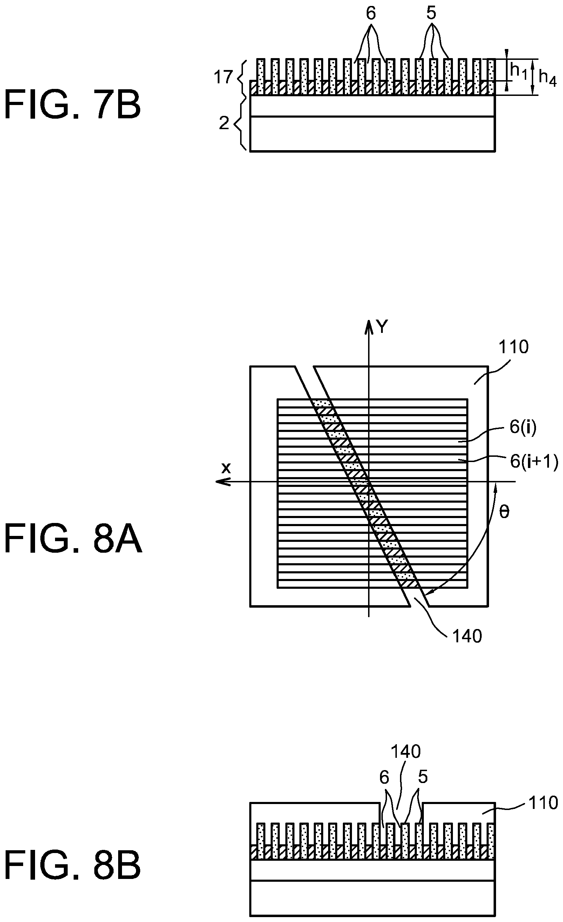

Puis il est procédé à une étape de gravure sélective d'un des deux types de matériau (figures 7A et 7B). Là encore, à titre d'exemple, le matériau gravé préférentiellement est le premier type de matériau. Ce premier type de matériau est gravé en tout point de l'alternance de couches 4(i) de façon à former des tranchées ou nano-tranchées 6(i) de profondeur h1, séparées l'une de l'autre par des parois 5(i) composées du deuxième type de matériau. Les largeurs des nano-tranchées 6(i) et des parois 5(i) les séparant sont respectivement égales aux épaisseurs des couches alternées composées du premier type de matériau et de celles des couches composées du second type de matériau. Le fond des nano-tranchées 6(i) est composé du premier type de matériau.

Sur ce réseau de nano-tranchées 6(i) est déposé un masque de lithographie 110 (figures 8A et 8B). Ce masque peut être en résine de photolithographie. Une zone découverte 140 est formée en éliminant la résine dans cette zone. Cette zone laisse donc apparaître localement l'alternance de couches 4(i), particulièrement le matériau composant le fond des nano-tranchées 6(i).

Avantageusement la zone découverte forme dans le masque 110 une tranchée 140 de largeur W et d'angle θ (0<θ≤90°) par rapport à la direction locale X des couches alternées 4(i) et des nano-tranchées 6(i). Dans la tranchée 140, la longueur L', mesurée suivant l'axe X, de la portion de chaque couche 4(i) non couverte par la résine 110 est alors égale à W/cos 90-θ). Les parois de cette tranchée sont rectilignes, perpendiculaires au plan XY, parallèles entre elles et forment un d'angle θ (0<θ≤90°) par rapport à la direction locale X des couches alternées 4(i).

Là encore, l'angle θ entre la tranchée de résine 140 et la direction locale X de l'alternance de couches, conduit à ce qu'il y ait une période P* suivant l'axe X entre deux portions de nano-tranchées sur-gravées 60(i) présentes dans deux nano-tranchées 6(i) voisines. P* est alors tel que P* = P/tan(θ).

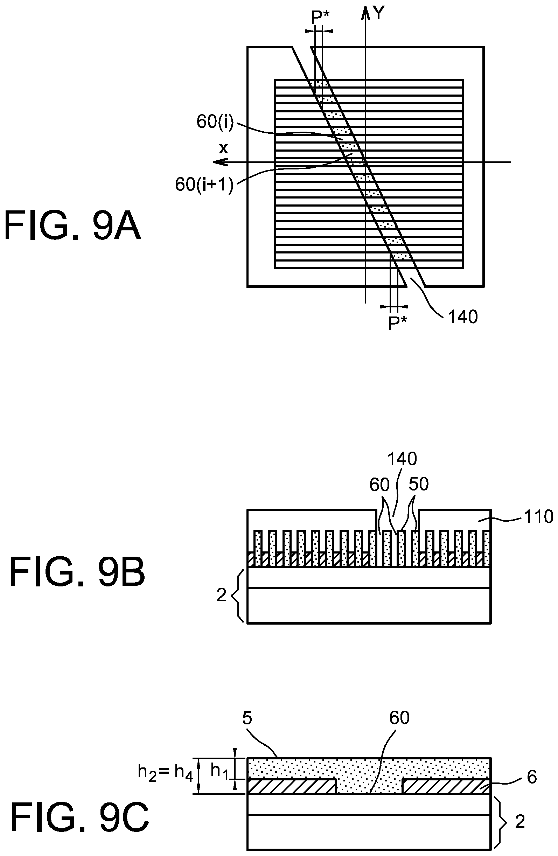

Il est ensuite procédé à une gravure sélective du premier type de matériau formant localement, dans les nano-tranchées 6(i) en premier matériau, une portion de nano-tranchée sur-gravée 60 (i), de profondeur h2 par rapport au niveau haut du sommet des parois composées dans le second type de matériau (figures 9A, 9B et 9C). Dans le cas présenté ici, à titre d'exemple, la profondeur h2 des zones sur-gravées est égale à l'épaisseur totale h4 des couches 4(i) composées du second matériau, formant les parois 5(i).

Avantageusement la gravure peut être anisotrope et grave alors uniquement les portions du premier type de matériau non couvertes par la résine (figures 9A, 9B et 9C); la longueur L des portions de nano-tranchées sur-gravées 60(i), mesurée suivant l'axe X, est alors égale à la longueur L', suivant l'axe X, de la portion de chaque couche 4(i) non couverte par la résine 110.

Alternativement, comme présenté dans le mode de réalisation précédent, la gravure peut être isotrope, le premier matériau étant alors localement gravé sous la couche de résine. La longueur L des portions des nano-tranchées sur-gravées est alors supérieure à L'.

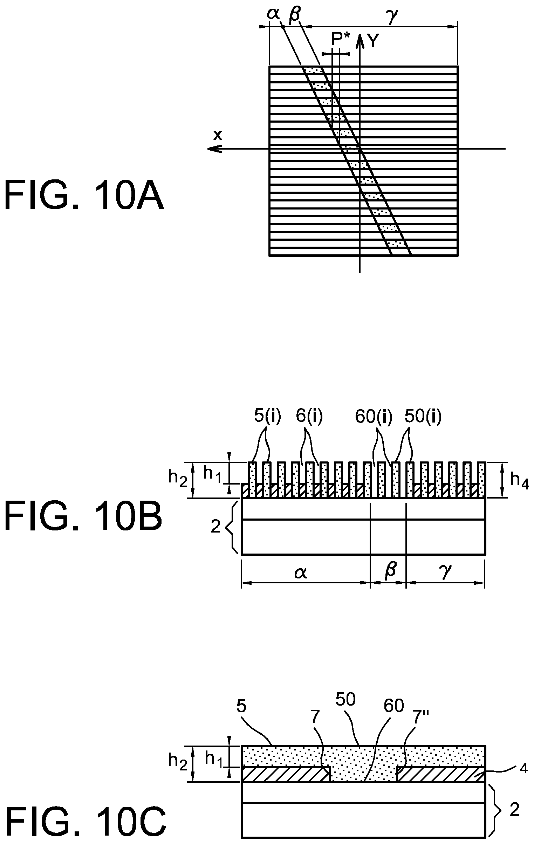

Ensuite, il est procédé au retrait de la résine 110 restante (figure 10A, 10B et 10C). Les zones sur-gravées 60(i), de profondeur h2, sont alors comprises, dans le sens de la longueur de l'alternance de couches, chacune dans une nano-tranchée 6(i) de profondeur h1.

Il est ainsi formé une structure comprenant au moins une nano-tranchée de profondeur h1 dont une partie a une profondeur h2. Dans le cas d'un réseau de couches alternées 4(i), il est formé un réseau de nano-tranchées 6(i) ayant une profondeur h1 et, dans chaque nano-tranchée, une portion 60(i) de profondeur h2, de longueur L et telle qu'il y a, selon l'axe X des nano-tranchées, une périodicité P* entre deux portions sur-gravées 60(i) présentes dans deux nano-tranchées 6(i) voisines.

Le réseau de couches alternées comporte alors trois zones (figure 9A):
- une zone « profonde » (β) composée d'une alternance de portions de nano-tranchées 60(i) de profondeur h2 séparées par des parois 50(i) composées par le deuxième type de matériau ; cette zone a les caractéristiques géométriques déjà indiquées ci-dessus : une largeur W et un angle θ par rapport à la direction locale X des couches alternées 4(i), les portions de profondeur h2 ayant une période P* selon cet axe X,
- de chaque coté de la zone profonde, un réseau (α et γ) de nano-tranchées 6(i) de profondeur h1, dont le fond est composé du premier type de matériau, séparées par des parois 5(i), de niveau haut, composées du second type de matériau.

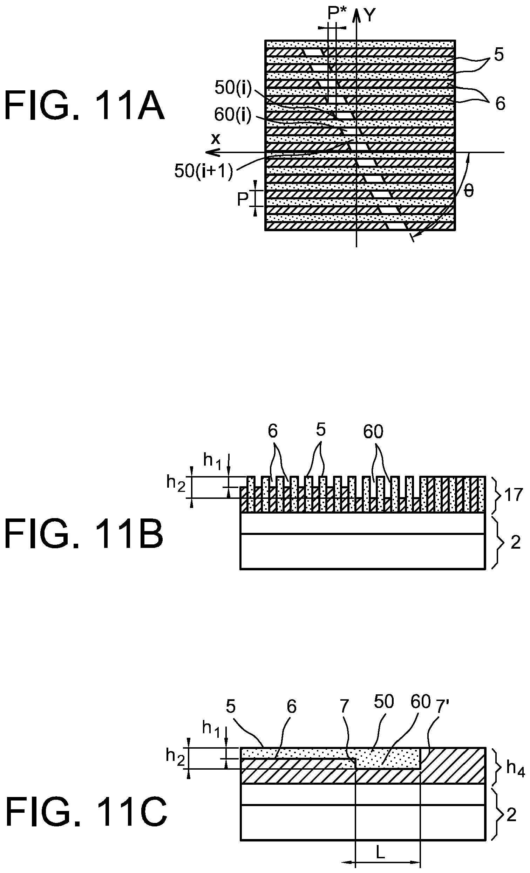

L'invention concerne aussi deux dispositifs, illustrés en figures 11A à 12C. Les notations et symboles (P, P*, h1, h2,... etc.) utilisés dans la suite ont la même signification que précédemment. Dans le cas des procédés et dispositifs présentés, une couche superficielle 3 en oxyde peut être comprise entre la couche composite et le substrat. De façon alternative, le dispositif ne contient pas de couche superficielle 3.

Un premier mode de réalisation d'un dispositif selon l'invention comporte au moins une nano-tranchée de profondeur h1 par rapport au niveau haut des bords de la tranchée, dont le fond est composé en un premier matériau. Les parois de cette tranchée sont composées en un deuxième type de matériau.

Avantageusement, le dispositif contient plusieurs nano-tranchées 6(i), disposées en un réseau dans lequel l'alternance paroi 5(i) /nano-tranchée 6(i) a une période P (figures 11A, 11B et 11C). Les largeurs des parois 5(i) sont préférentiellement égales ; les largeurs des nano-tranchées 6(i) sont préférentiellement égales entre elles. Les largeurs et la période des parois 5(i) et des nano-tranchées 6(i) sont celles déjà indiquées ci-dessus pour les couches alternées 4(i) en liaison avec la figure 2A.

Au moins à une extrémité de chaque nano-tranchées 6(i), il y a une longueur L de zone sur-gravée 60(i) de profondeur h2.

La ou les zone(s) sur-gravée(s) 60(i), de profondeur h2, sont entourées de quatre parois.

Les deux parois 50(i) et 50(i-1) présentes selon la direction perpendiculaire à la direction principale des nano-tranchées 6(i) sont composées du second type de matériau et ont une hauteur h2 mesurée depuis le fond de la portion de nano-tranchée sur-gravée 60(i) et suivant la direction Z.

Selon la direction principale X des nano-tranchées, les parois de la zone sur-gravée sont composées du premier type de matériau. Du coté de la nano-tranchée 6(i) de profondeur h1, la paroi 7 a une hauteur de valeur h2-hl. De l'autre coté, la paroi 7' a une hauteur h2 et son niveau le plus élevé correspond au niveau haut des parois 50(i) composées du second type de matériau.

Dans le cas où il y a plusieurs nano-tranchées 6(i), il y a au moins une portion de nano-tranchée sur-gravée 60(i) présente à au moins une extrémité de chaque nano-tranchée 6(i). Les nano-tranchées 6(i) ont leur portion sur-gravée 60(i) du même coté. Les parois 7(i) ou 7'(i) en premier matériau de ces tranchées peuvent être avantageusement décalées les unes par rapport aux autres de sorte qu'elles sont alignées selon une direction formant un angle θ (0<θ≤90°) avec la direction X. Il y a alors selon l'axe de la direction locale X des nano-tranchées 6(i), une période P* (telle que déjà définie ci-dessus) entre deux parois 7'(i) de hauteur h2 de deux zones sur-gravées 60(i) et 60(i+1) présentes à l'extrémité de deux nano-tranchées 6(i) voisines.

Un deuxième mode de réalisation d'un dispositif selon l'invention comporte au moins une nano-tranchée de profondeur h1 par rapport au niveau haut des bords de la tranchée, dont le fond est composé en un premier matériau. Les parois de cette nano-tranchée sont composées en un deuxième type de matériau.

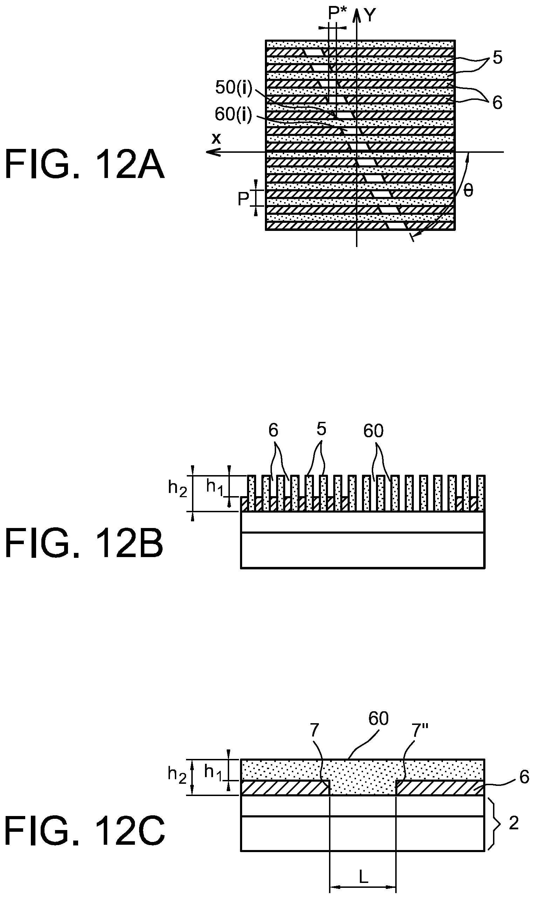

Avantageusement, le dispositif contient plusieurs nano-tranchées 6(i), disposées en un réseau dans lequel l'alternance paroi 5(i) /nano-tranchée 6(i) a une période P (figures 12A, 12B et 12C). Les largeurs des parois 5(i) sont préférentiellement égales ; les largeurs des nano-tranchées 6(i) sont préférentiellement égales entre elles. Les largeurs et la période des parois 5(i) et des nano-tranchées 6(i) sont celles déjà indiquées ci-dessus pour les couches alternées 4(i) en liaison avec la figure 2A.

Dans au moins chaque nano-tranchées 6(i), il y a une longueur L de zone sur-gravée 60 (i) de profondeur h2.

La ou les zone(s) sur-gravée (s) 60 (i), de profondeur h2, sont entourées de quatre parois :
- les deux parois 50 (i) et 50(i-1) présentes selon la direction Y perpendiculaire à la direction principale des nano-tranchées 6(i) sont composées du second type de matériau et ont une hauteur h2 mesurée depuis le fond de la portion de nano-tranchée sur-gravée 60(i) et suivant la direction Z.
- selon la direction principale X des nano-tranchées, les deux parois de la zone sur-gravée sont composées du premier type de matériau et de ces deux cotés, chaque zone surgravée 60(i) est prolongée par une nano-tranchée 6(i) de profondeur h1. Les deux parois 7(i) et 7"(i) correspondant ont une hauteur de valeur h2-h1.

Dans le cas où il y a plusieurs nano-tranchées 6(i), il y a au moins une portion de nano-tranchée sur-gravée 60(i) présente dans chaque nano-tranchée 6(i). Les parois 7(i) ou 7''(i) en premier matériau de ces tranchées peuvent être avantageusement décalées les unes par rapport aux autres de sorte qu'elles sont alignées selon une direction formant un angle θ (0<θ≤90°) avec la direction X. Il y a alors selon l'axe de la direction locale X des nano-tranchées 6(i), une période P* (telle que déjà définie ci-dessus) entre deux parois 7(i) de deux zones sur-gravées 60(i) et 60(i+1) présentes dans deux nano-tranchées 6(i) voisines.

Dans un procédé ou un dispositif selon l'invention, les matériaux composant l'alternance de couches alternées 4(i) sont choisis parmi Si, SiGe, SiO2, HfO2, Si3N4, ZrO ; par exemple les couples de matériaux retenus pour le premier matériau et le deuxième matériau peuvent être Si/SiGe, Si/SiO2, ou le couple HfO2/SiO2, ou le couple SiO2/Si3N4, ou le couple ZrO2/SiO2 ou encore des couples de matériaux métalliques. Dans chaque cas il est possible de graver préférentiellement l'un ou l'autre des deux matériaux.

Il est encore possible d'incorporer plus de deux matériaux parmi ceux pré-cités, en choisissant des matériaux pouvant être gravés de façon sélective les uns par rapport aux autres, de façon à avoir des variations des profondeurs individuelles des nano-tranchées, l'une par rapport à l'autre. Il est aussi possible de choisir des types de matériaux de telle sorte qu'il puisse y avoir des variations de composition, et donc de vitesse de gravure, entre deux couches composées d'un même type de matériau.

Dans un dispositif selon l'invention et/ou fabriqué selon un procédé selon l'invention, les tranchées 6(i) et 60(i) et les parois 5(i) et 50(i) ont des épaisseurs comprises entre 1 nm et 50 nm, préférentiellement comprises entre 5 nm et 30 nm. Par exemple, les couches ont une même épaisseur d'environ 10 nm +/- 2 nm ou même 7 nm +/- 2 nm, ou encore 5 nm +/- 1 nm.

Un dispositif selon l'invention et un procédé selon l'invention sont avantageusement tels que la période P* selon l'axe X entre deux zones sur-gravées 60 (i) et 60(i+1) est plus importante que la période minimale pouvant être obtenue pour un réseau de motifs par des moyens de lithographie optique standards.

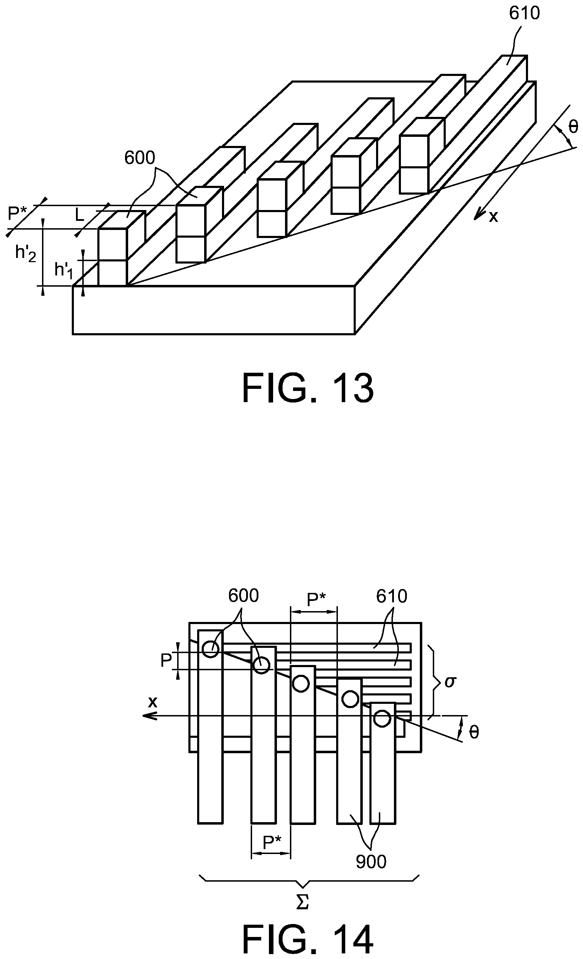

En effet, un dispositif selon l'invention, et/ou fabriqué selon un procédé selon l'invention, peut être utilisé comme moule pour produire des motifs par nano-impression dans une couche de polymère recouvrant un substrat « produit », ou comme négatif de façon à former des moules de Nano-Impression (figure 13).

Les motifs 610 et 600 alors obtenus ont deux niveaux différents h1' et h2' correspondant respectivement aux zones de nano-tranchées et aux zones de nano-tranchées sur-gravées du moule de nano-impression. Les zones du moule ayant une profondeur plus importante conduisent, lors de la formation de motifs par nano-impression, à former des portions de motifs 600 plus élevées.

Dans le cas où la période P* est supérieure à la période minimale pouvant être obtenue pour un réseau de motifs par des moyens de lithographie optique standards, après la formation d'un réseau « σ » de motifs 610 par nano-impression, il est possible de connecter le réseau « σ » de motifs conducteurs à un niveau supérieur (figure 14). En effet, ce contact est possible en formant, par des moyens de lithographie optique, un réseau « Σ » de lignes 900 orientés localement selon l'axe Y, de période égale à la période P* des portions de nano-tranchées sur-gravées, et positionné de façon à prendre contact sur les portions de motifs surélevés 600.

La prise de contact entre le niveau supérieur « Σ » et le niveau de nano-tranchées « σ » se fait donc sur les plots formés par les motifs surélevés 600, ce qui évite que la formation d'un via par des moyens de lithographie optique ne crée de court-circuits entre deux nano-motifs 610.

## Revendications

1. Dispositif de nano-impression à trois dimensions comportant au moins :
a) un substrat (2), présentant une surface (X, Y),
b) et, sur ce substrat, une pluralité de nano-tranchées (6) parallèles deux à deux, chaque nano tranchée s'étendant suivant une direction longitudinale (X) et étant délimitée latéralement par deux parois latérales, les nano-tranchées et les parois latérales étant dirigées perpendiculairement à ladite surface du substrat, le fond de chaque nano-tranchée comportant, suivant la direction longitudinale (X), au moins un premier et un deuxième niveaux selon une direction perpendiculaire à la surface du substrat, respectivement de profondeurs h1 et h2>h1, mesurées par rapport au sommet des parois latérales,
c) le fond des nano-tranchées, du niveau le moins profond (hl), étant en un premier type de matériau, les parois latérales étant en un deuxième type de matériau, le premier type de matériau pouvant être gravé sélectivement par rapport au deuxième type de matériau composant les parois latérales de la nano-tranchée.

2. Dispositif selon la revendication 1, ladite pluralité de nano-tranchées (6(i)) séparées par des parois latérales (5(i)) formant un réseau de nano-motifs et de nano-tranchées, chaque portion de nano tranchée de profondeur h2 étant décalée, par rapport à une portion d'une nano tranchée voisine, d'une période P*, selon ladite direction longitudinale.

3. Dispositif selon la revendication 1, les parties les plus profondes (60(i)), de profondeur h2, des nano-tranchées, ayant une longueur (L) inférieure à la période P*.

4. Dispositif selon l'une des revendications 1 à 3, chaque partie profonde (60(i)) de profondeur h2, étant à une extrémité d'une nano-tranchée (6(i)), et étant délimitée par quatre faces :
- une face composée du premier type de matériau, de hauteur h2-h1,
- deux faces formées par deux parois latérales composées du deuxième type de matériau,
- une face composée du premier type de matériau, de profondeur h2, et dont le sommet est au même niveau que celui des parois latérales entourant la nano-tranchée.

5. Dispositif selon l'une des revendications 1 à 4, dans lequel la largeur des nano-motifs (5(i)) et des nano-tranchées (6(i)) est inférieure ou égale à 10 nm +/- 2 nm.

6. Procédé de formation d'un moule d'impression en trois dimensions comportant au moins :
a) la formation de couches alternées (4(i), i=1...n)) sur une surface d'un substrat (2), au moins partiellement parallèles entre elles selon une direction longitudinale (X), et au moins partiellement perpendiculairement à la surface du substrat, d'un premier type de matériau et d'un deuxième type de matériau, le premier type de matériau pouvant être gravé sélectivement par rapport au deuxième type de matériau,
b) la formation, par gravure sélective partielle du premier type de matériau par rapport au deuxième type de matériau, de portions de nano-tranchées (60(i)) et de parois latérales, perpendiculaires à ladite surface du substrat, le fond de chaque nano-tranchée comportant au moins un premier et un deuxième niveaux, selon la direction longitudinale (X), respectivement de profondeurs h1 et h2>h1 selon une direction perpendiculaire au substrat, mesurées par rapport au sommet des parois latérales.

7. Procédé selon la revendication 6, l'étape b) comportant la formation, sur les couches alternées, d'un masque (110), comportant au moins une zone ouverte (140) laissant découverte une zone des couches alternées, au moins une partie de la gravure sélective partielle étant réalisée à travers le masque (110).

8. Procédé selon la revendication 7, l'étape b) comportant:
- une première gravure sélective partielle avant formation du masque, permettant de graver au moins une partie des couches alternées en premier type de matériau à la profondeur h1,
- la formation du masque,
- une deuxième gravure sélective partielle à travers ladite zone ouverte (140) du masque, permettant de graver une partie des couches alternées en premier type de matériau, déjà gravées lors de la première gravure sélective partielle à la profondeur h1, à la profondeur h2>h1;
- le retrait d'au moins une partie du masque.

9. Procédé selon la revendication 7, l'étape b) comportant:
- la formation du masque,
- une première sous étape de gravure sélective partielle à travers ladite zone ouverte (40) du masque, permettant de graver une partie des couches alternées en premier type de matériau à une profondeur hᵢₙₜ,
- le retrait d'une partie du masque ;
- une deuxième sous étape de gravure sélective partielle, au moins une partie des couches alternées en premier type matériau, gravées lors de la première sous étape, étant alors gravées à la profondeur h2, et une partie des couches alternées, en premier type matériau, recouvertes par le masque lors de la première sous étape, étant alors gravée à la profondeur h1.
- le retrait d'au moins une partie du masque.

10. Procédé selon la revendication 9, toutes les couches alternées (4(i)) ayant le même niveau avant formation du masque (110).

11. Procédé selon l'une des revendications 7 à 10, dans lequel la zone ouverte (140) dans le masque (110) forme une tranchée ayant un angle θ avec la direction (X) de la longueur des lignes formées par l'alternance de couches (4(i)), les portions de tranchées (60(i)) gravées dans deux couches voisines composées du premier type de matériau ayant une période P* entre elles suivant un axe formé par une direction d'extension des couches.

12. Procédé selon l'une des revendications 6 à 11, dans lequel l'épaisseur de chaque couche est inférieure ou égale à 10 nm +/- 2 nm.

13. Procédé de formation de motifs dans une résine, comportant une impression, dans une couche de ladite une résine, avec un dispositif de nano-impression selon l'une des revendications 1 à 5.

14. Procédé selon la revendication 13, comportant la formation, sur un substrat, d'un réseau de nano-motifs en résine (610) comportant des plots (600) de sommet situé à une première hauteur h'2 par rapport à une surface dudit substrat, et des motifs (610) de hauteur h1'<h'2 par rapport à la même surface et s'étendant suivant une direction commune d'extension des motifs.

15. Procédé selon la revendication 14, comportant en outre la formation de contacts entre lesdits plots et des lignes d'interconnexion.

## Patentansprüche

1. Vorrichtung zum 3D-Nanodruck, enthaltend zumindest:
a) ein Substrat (2) mit einer Oberfläche (X, Y),
b) und auf diesem Substrat eine Vielzahl von paarweise parallel verlaufenden Nanogräben (6), wobei jeder Nanograben sich in einer Längsrichtung (X) erstreckt und seitlich von zwei Seitenwänden eingegrenzt wird, wobei die Nanogräben und die Seitenwände senkrecht zur Oberfläche des Substrats gerichtet sind, wobei der Boden eines jeden Nanograbens in Längsrichtung (X) zumindest ein erstes und ein zweites Niveau in zur Oberfläche des Substrats senkrechter Richtung mit der Tiefe h1 bzw. h2>h1, gemessen bezüglich des Scheitels der Seitenwände, aufweist,
c) wobei der Boden der Nanogräben auf dem weniger tiefen Niveau (h1) aus einem ersten Materialtyp besteht, wobei die Seitenwände aus einem zweiten Materialtyp bestehen, der erste Materialtyp bezüglich des zweiten Materialtyps, der die Seitenwände des Nanograbens bildet, selektiv geätzt werden kann.

2. Vorrichtung nach Anspruch 1, wobei die Vielzahl der durch die Seitenwände (5(i)) getrennten Nanogräben (6(i)) ein Netz aus Nanomustern und Nanogräben bildet, wobei jeder Nanograbenabschnitt der Tiefe h2 bezüglich eines benachbarten Nanograbenabschnitts um eine Periode P* in der Längsrichtung versetzt ist.

3. Vorrichtung nach Anspruch 1, wobei die tieferen Teile (60(i)) der Nanogräben mit der Tiefe h2 eine Länge (L) kleiner als die Periode P* haben.

4. Vorrichtung nach einem der Ansprüche 1 bis 3, wobei jedes tiefe Teil (60(i)) der Tiefe h2 an einem Ende eines Nanograben (6(i)) liegt und durch vier Seiten begrenzt wird:
- einer aus dem ersten Materialtyp bestehenden Seite der Höhe h2-h1,
- zwei Seiten, die aus zwei Seitenwänden aus dem zweiten Materialtyp gebildet sind,
- einer aus dem ersten Materialtyp bestehenden Seite der Tiefe h2, deren Scheitel auf dem gleichen Niveau wie die den Nanograben umgebenen Seitenwände liegt.

5. Vorrichtung nach einem der Ansprüche 1 bis 4, wobei die Breite der Nanomuster (5(i)) und der Nanogräben (6(i)) geringer oder gleich 10 nm +/- 2 nm ist.

6. Verfahren zum Bilden zumindest einer 3D-Druckform, zumindest umfassend:
a) Bilden von abwechselnden Schichten (4(i), i = 1 ... n) auf einer Oberfläche eines Substrats (2), die zumindest teilweise parallel zueinander in einer Längsrichtung (X) und zumindest teilweise senkrecht zur Oberfläche des Substrats verlaufen und aus einem ersten Materialtyp und einem zweiten Materialtyp bestehen, wobei der erste Materialtyp bezüglich des zweiten Materialtyps selektiv geätzt werden kann,
b) Bilden von Abschnitten von Nanogräben (60(i)) und Seitenwänden, die senkrecht zur Oberfläche des Substrats verlaufen, durch teilweises, selektives Ätzen des ersten Materialtyps bezüglich des zweiten Materialtyps, wobei der Boden eines jeden Nanograbens zumindest ein erstes und ein zweites Niveau in Längsrichtung (X) mit der Tiefe h1 bzw. h2>h1 in einer Richtung senkrecht zum Substrat, gemessen bezüglich des Scheitels der Seitenwände, aufweist.

7. Verfahren nach Anspruch 6, wobei der Schritt b) das Bilden einer Maske (110) auf den abwechselnden Schichten umfasst, die zumindest einen offenen Bereich (140) aufweist, der einen Bereich der abwechselnden Schichten unbedeckt lässt, wobei zumindest ein Teil des teilweisen, selektiven Ätzens durch die Maske (110) hindurch erfolgt.

8. Verfahren nach Anspruch 7, wobei der Schritt b) umfasst:
- ein erstes, teilweises, selektives Ätzen vor dem Ausbilden der Maske, wodurch zumindest ein Teil der abwechselnden Schichten aus dem ersten Materialtyp mit der Tiefe h1 geätzt werden kann,
- Ausbilden der Maske,
- ein zweites, teilweises, selektives Ätzen durch den offenen Bereich (140) der Maske, wodurch ein Teil der abwechselnden Schichten aus dem ersten Materialtyp, die bereits beim ersten teilweisen, selektiven Ätzen mit der Tiefe h1 geätzt wurden, mit der Tiefe h2>h1 geätzt werden kann;
- Entfernen zumindest eines Teils der Maske.

9. Verfahren nach Anspruch 7, wobei Schritt b) umfasst.
- Ausbilden der Maske,
- einen ersten Unterschritt zum teilweisen, selektiven Ätzen durch den offenen Bereich (40) der Maske hindurch, wodurch ein Teil der abwechselnden Schichten aus dem ersten Materialtyp mit einer Tiefe hᵢₙₜ geätzt werden kann,
- Entfernen eines Teils der Maske,
- einen zweiten Unterschritt zum teilweisen, selektiven Ätzen, wobei zumindest ein Teil der abwechselnden Schichten aus dem ersten Materialtyp, die beim ersten Unterschritt geätzt wurden, dann mit der Tiefe h2 geätzt werden kann, wobei ein Teil der abwechselnden Schichten aus dem ersten Materialtyp, die beim ersten Unterschritt mit der Maske bedeckt waren, dann mit der Tiefe h1 geätzt werden,
- Entfernen zumindest eines Teils der Maske.

10. Verfahren nach Anspruch 9, wobei alle abwechselnden Schichten (4(i)) vor dem Ausbilden der Maske (110) das gleiche Niveau haben.

11. Verfahren nach einem der Ansprüche 7 bis 10, wobei der offene Bereich (140) in der Maske (110) einen Graben unter einem Winkel θ mit der Richtung (X) der Länge der aus der Wechselfolge von Schichten (4(i)) gebildeten Zeilen bildet, wobei die Abschnitte der Gräben (60(i)), die in zwei benachbarten Schichten aus dem ersten Materialtyp geätzt sind, eine Periode P* zwischen sich entlang einer durch eine Erstreckungsrichtung der Schichten gebildeten Achse haben.

12. Verfahren nach einem der Ansprüche 6 bis 11, wobei die Dicke einer jeden Schicht geringer oder gleich 10 nm +/- 2 nm ist.

13. Verfahren zum Bilden von Mustern aus einem Harz mit einem Druck in einer Schicht aus dem einen Harz, mit einer Vorrichtung zum Nanodruck nach einem der Ansprüche 1 bis 5.

14. Verfahren nach Anspruch 13, umfassend das Bilden eines Netzes von Nanomustern aus Harz (610) auf einem Substrat, die Zapfen (600) enthalten, deren Scheitel auf einer ersten Höhe h'2 bezüglich einer Oberfläche des Substrats liegt, sowie Muster (610) der Höhe h1'<h'2 bezüglich der gleichen Oberfläche, die sich in einer gemeinsamen Erstreckungsrichtung der Muster erstrecken.

15. Verfahren nach Anspruch 14, ferner umfassend das Ausbilden von Kontakten zwischen den Zapfen und Verbindungsleitungen.

## Claims

1. Nano-imprint device with three dimensions, comprising at least:
a) a substrate (2), having a surface (X, Y),
b) and, on this substrate, a plurality of nano-trenches (6) parallel two by two, each nano-trench extending in a longitudinal direction (X) and being delimited laterally by two side walls, the nano-trenches and the side walls being directed perpendicular to said surface of the substrate, the bottom of each nano-trench comprising, along the longitudinal direction (X), at least one first and one second level in a direction perpendicular to the surface of the substrate, respectively of depths h1 and h2>h1, measured relative to the top of the side walls,
c) the bottom of the nano-trenches, of the least deep level (h1) being in a first type of material, the side walls being in a second type of material, the first type of material able to be etched selectively relative to the second type of material forming the side walls of the nano-trench.

2. Device according to claim 1, said plurality of nano-trenches (6(i)) separated by side walls (5(i)) forming an array of nano-patterns and of nano-trenches, each portion of nano-trench of depth h2 being offset from a portion of an adjacent nano-trench by a period P*, in said longitudinal direction.

3. Device according to claim 1, the deepest parts (60(i)), of depth h2, of the nano-trenches having a length (L) shorter than period P*.

4. Device according to any of claims 1 to 3, each deep part (60(i)) of depth h2 lying at one end of a nano-trench (6(i)), and being delimited by four faces:
- one face consisting of said first type of material, of height h2-h1,
- two faces formed by two side walls consisting of said second type of material,
- one face consisting of said first type of material, of depth h2, and whose top is at the same level, as the top of the walls surrounding the nano-trench.

5. Device according to any of claims 1 to 4, wherein the width of the nano-patterns (5(i)) and of the nano-trenches (6(i)) is equal to or less than 10 nm +/- 2 nm.

6. Method to form an imprint mould in three dimensions, comprising at least:
a) forming alternate layers (i), i=1...n)) on a surface of a substrate (2), at least partly parallel to each other along a longitudinal direction (X) and at least partly perpendicular to the surface of the substrate, in a first type of material and a second type of material, the first type of material able to be etched selectively relative to the second type of material,
b) forming, by partial selective etching of the first type of material relative to the second type of material, portions of nano-trenches (60(i)) and of side walls, perpendicular to said surface of the substrate, the bottom of each nano-trench comprising at least one first and one second levels, along the longitudinal direction (X), respectively of depth h1 and h2>h1 in a direction perpendicular to the substrate, measured relative to the top of the side walls.

7. Method according to claim 6, step b) comprising the formation, on the alternate layers, of a mask (110) comprising at least one open region (140) exposing a region of alternate layers, at least part of the partial selective etching being made through the mask (110).

8. Method according to claim 7, step b) comprising:
- a first partial selective etch before formation of the mask, allowing the etching of at least part of the alternate layers in the first type of material to depth h1,
- forming the mask,
- a second partial selective etch, through said open region (140) of the mask, permitting the etching of part of the alternate layers in the first type of material, already etched during the first partial selective etch to depth h1, down to a depth h2>h1;
- removing at least part of the mask.

9. Method according to claim 7, step b) comprising:
- forming the mask,
- a first sub-step of partial selective etching through said open region (40) of the mask, permitting the etching of part of the alternate layers in first type of material to a depth hᵢₙₜ,
- removing part of the mask;
- a second sub-step of partial selective etching, in which at least part of the alternate layers in first type of material etched during the first sub-step is then etched to depth h2, and part of the alternate layers in first type of material covered by the mask during the first sub-step then being etched to depth h1,
- removing at least part of the mask.

10. Method according to claim 9, all the alternate layers (4(i)) having the same level before formation of the mask (110).

11. Method according to any of claims 7 to 10, wherein the open region (140) in the mask (110) forms a trench having an angle θ with the direction (X) of the length of the lines formed by the alternation of layers (4(i)), the portions of trenches (60(i)) etched in two adjacent layers consisting of the first type of material having a period P* between each other along an axis formed by an extension direction of the layers.

12. Method according to any of claims 6 to 11, wherein the thickness of each layer is equal to or less than 10 nm +/- 2 nm.

13. Method to form patterns in a resin, comprising an imprint, in a layer of said resin, with a nano-imprinting device according to any of claims 1 to 5.

14. Method according to claim 13, comprising the formation, on a substrate, of an array of nano-patterns in resin (610) comprising top pads (600) located at a first height h'2 relative to a surface of said substrate, and patterns (610) of height h1'<h'2 relative to the same surface and extending in a common extension direction of the patterns.

15. Method according to claim 14, further comprising the formation of contacts between said pads and interconnection lines.
